# EUROPEAN PATENT SPECIFICATION

(11) **EP 2 184 965 B1**
(45) Date of publication and mention of the grant of the patent: **09.03.2011**
(21) Application number: 08168584.4
(22) Date of filing: 07.11.2008
(51) Int. Cl.: H05K 13/04

(54) **Camera module insertion machine with gripper**
Kameramodul-Einsetzmaschine mit Greifer
Machine d'insertion de module de caméra doté d'un préhenseur

(43) Date of publication of application: 12.05.2010
(73) Proprietor: RESEARCH IN MOTION LIMITED, Waterloo, Ontario N2L 3W8 (CA)
(72) Inventor: Zhang, Richard Changchun, Waterloo, Ontario N2T 0A1 (CA); Zhang, Ming, Waterloo, Ontario N2V 2R7 (CA); Ellis ,Brent, Cambridge, Ontario N3C 3Y7 (CA); Doyle, Fintan, Waterloo, Ontario N2L 3W8 (CA)
(74) Representative: MERH-IP Matias Erny Reichl Hoffmann

(56) References cited:
- US-A- 4 161 064
- US-A- 4 420 878
- US-A- 5 306 166

## Description

### FIELD

The technology described in this patent document relates generally to the field of manufacturing and more particularly to the field of manufacturing mobile devices.

### BACKGROUND

Electronic devices are typically assembled with automated systems or in combination with manual labor. Sensitive components such as camera units require special handling to prevent them from being damaged, and it has proven difficult to use automated systems effectively for inserting such components into sockets in electronic devices. Manual assembly is an alternative for handling such components. However, manual assembly also has problems. Human error, such as failure to correctly orient or fully secure the component, is a common issue with manual assembly. Furthermore, manual assembly typically costs more than automated systems.

US4420878 describes automated systems for mounting and inserting dual-in-line type of components (DIP) and sockets. US4161064 discloses an apparatus for seating an electronic component within a socket, comprising a gripper and an insertion depth guide associated with the gripper.

### SUMMARY

An example assembly system, gripper apparatus, and method are presented herein. These examples provide a solution for orientation control, force control, insertion depth control, and positioning of the contact points to avoid pressure sensitive areas on components.

A system according to the present invention comprises a pressure sensitive electronic component, a socket and an apparatus for seating the component within the socket, as defined in claim 1.

An apparatus for seating a pressure sensitive electronic component within a socket according to the present invention is defined in claim 7.

A method for placing a pressure sensitive electronic component according to the present invention is defined in claim 13.

### BRIEF DESCRIPTION OF THE DRAWINGS

Fig. 1 shows a perspective view of an example assembly mechanism that includes an example gripper apparatus;
Fig. 2 is a magnified, perspective view of an example gripper apparatus and an example assembly track;
Fig. 3 is a second, magnified, perspective view of an example gripper apparatus and an example assembly track;
Fig. 3A shows a cross-sectional view of an example gripper apparatus and an example assembly track;
Fig. 4 shows a third, magnified, perspective view of an example gripper apparatus and an example assembly track;
Fig. 4A shows a perspective view of an example electronic component;
Fig. 4B shows a top-down cross-sectional view of example gripper corner extensions and an example socket;
Fig. 5 shows a cross-sectional view of an example gripper apparatus and an example assembly track;
Fig. 6 shows a perspective view of an assembly mechanism including an example gripper apparatus, an example control block and insertion height control rod, and an example assembly track;
Fig. 7 shows a magnified perspective view of an example gripper apparatus including an example control block and insertion height control rod, and an example assembly track;
Fig. 8 shows a cross-sectional view of an example gripper apparatus with an example control block and insertion height control rod, and an example assembly track;
Fig. 9 shows a top-down cross-sectional view of an example control block and an example socket; and
Fig. 10 is an example flow-chart of an assembly process using an example assembly mechanism.

### DETAILED DESCRIPTION

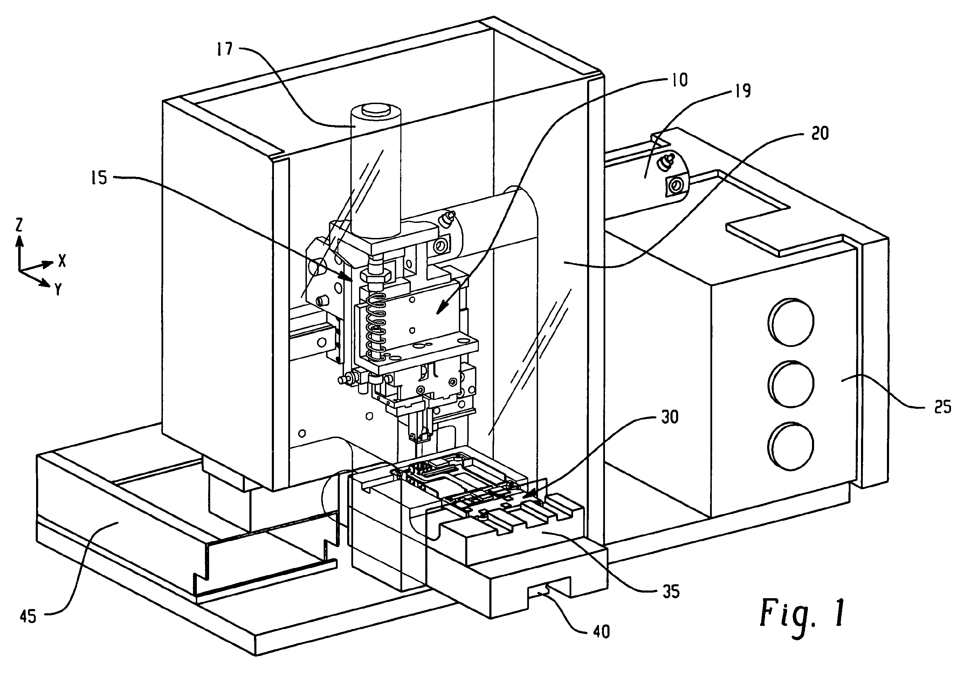

Fig. 1 shows a general overview of an example gripper apparatus assembly system. A gripper assembly 10 is secured to a gripper support structure 15. An air cylinder 17 is also mounted on the support structure 15 and is coupled to the gripper assembly 10. These components are enclosed in a machine guard 20. An electrical enclosure 25 houses a power source and computer controller (not shown) that provides power and computer control to the gripper assembly 10 through an electrical coupling. The gripper assembly 10 is pneumatically operated with a built in centering device. Beneath the gripper assembly 10 is a printed circuit board (PCB) 30 that is nestled in a PCB nest 35. In other examples, another part to be assembled may be used in place of the PCB 30. The PCB nest 35 and PCB 30 travel along a rail 40 in and out from under the gripper assembly 10. Each PCB 30 stops at a pre-determined location underneath the gripper assembly 10 and then moves out after an electronic component is installed. A tape feeder 45 is situated to the side of the gripper assembly 10 (along the x-axis) and an opening is provided in the side and bottom of the machine guard 20 to allow the gripper assembly 10 to move along the x-axis and locate above the tape feeder 45. A corresponding opening is located in the top of the tape feeder 45. Electronic components are provided on a moving "tape" for the gripper assembly 10 to pick up and assemble into the PCB 30. In this example the "tape" moves alongside with the PCB nest 35 along the y-axis, providing an electronic component for each PCB that comes underneath the gripper assembly 10.

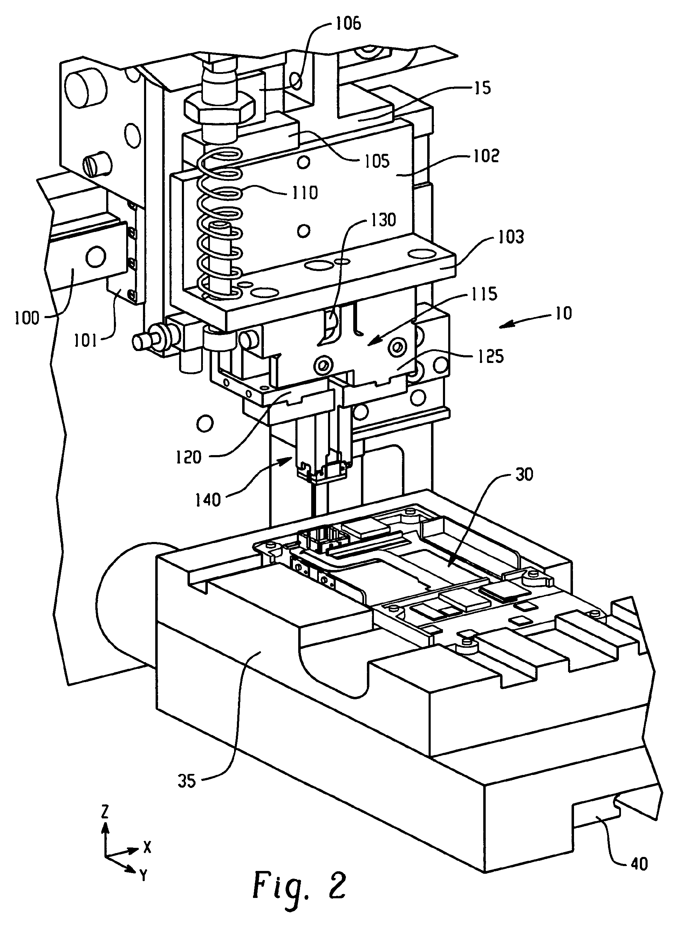

Fig. 2 shows a closer view of the example assembly system with the machine guard 20 removed from the view for clarity. The gripper assembly 10 is mounted on the support structure 15 so that the gripper assembly 10 can move relative to the support structure 15 on the z-axis. The air cylinder 17 is computer controlled and provides the force to move the gripper assembly 10 in the z-axis, although it is appreciated that other similar mechanisms may be suitable for enabling movement of the assembly 10. The support structure 15 is mounted on a rail 100 through a sliding x-axis mounting 101. This linear slide mechanism allows the support structure 15 and gripper assembly 10 to travel on the x-axis. Movement along the x-axis is powered by a computer-controlled air cylinder 19 (FIG. 1), although it is recognized that alternative mechanisms may be appropriate for providing movement of the assembly 10.

An L-shaped angled mounting plate 102 extends in the x and z plane and a bottom ledge 103 extends in the x and y plane. The L-shaped angled mounting plate 102 is secured to a sliding z-axis mounting 105 and, at the bottom ledge 103, is coupled to the gripper assembly 10 by a spring 110. The sliding z-axis mounting 105 is, in turn, coupled to a rail 106 on the support structure 15, forming a linear slide mechanism. The spring 110 provides force control to dampen the z-axis force provided from the air cylinder 17. In this example, the spring 110 is a coil spring; however, in other examples different types of springs may be used, or other types of biasing mechanisms may also be used. Furthermore, more than one spring or biasing mechanism may optionally be used, which may provide greater stability.

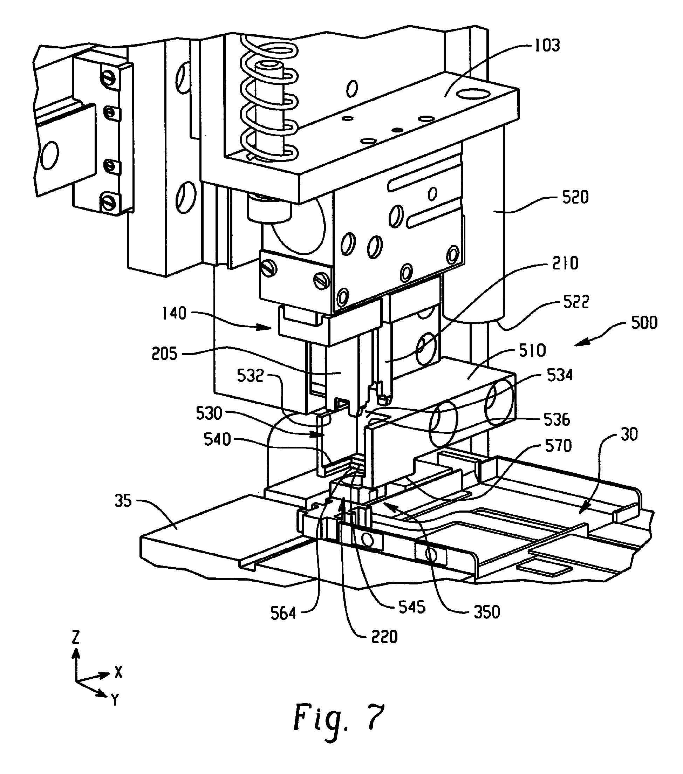

The spring 110 is attached to a two-part carriage 115, which is part of the gripper head 140, and which includes a first part 120 and a second part 125 that are attached by a sliding rod 130. In this example, the first part 120 and the second part 125 are slidable on a single-axis linear slide mechanism. Specifically, the second part 125 is slidably mounted on the rod 130 along the x-axis and is movable in relation to the first part 120, and the first part 120 is slidably mounted on the rod 130 along the x-axis and is movable in relation to the second part 125. When the first part 120 and second part 125 are moved apart, the gripper head 140 is in an open position (FIG.7), and when the first part 120 and second part 125 are moved together the gripper head 140 is in a closed position. In other examples, only one of the first part 120 and second part 125 are independently movable on the x-axis, and the other part is fixed. The movement is powered by the computer-controlled air cylinder (not shown).

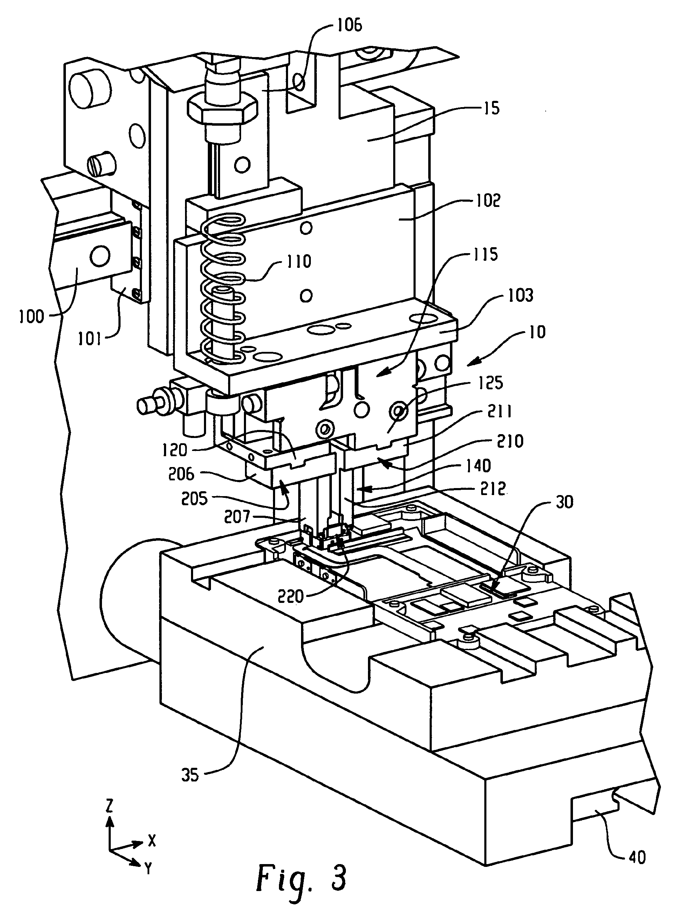

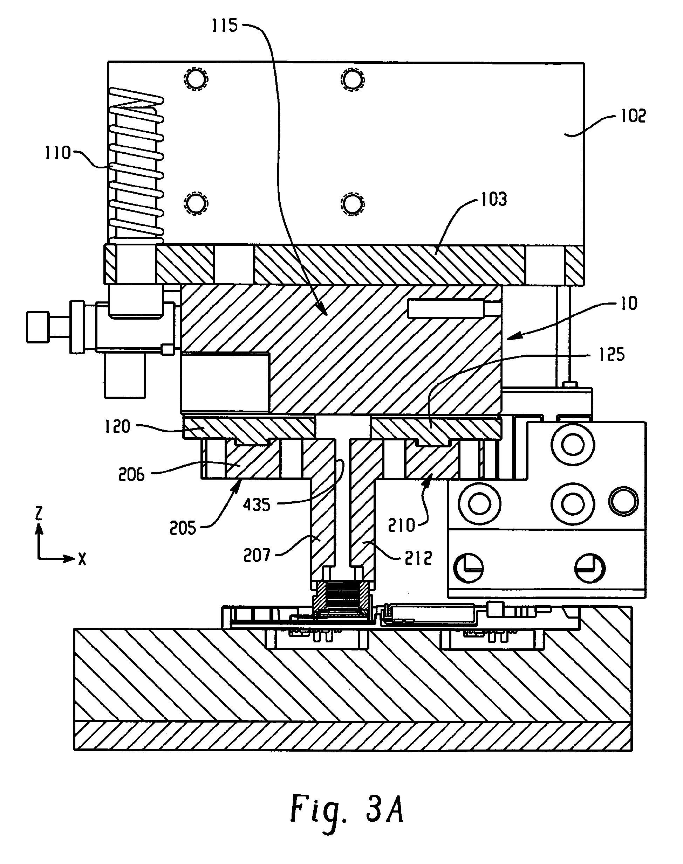

A gripper head 140 is attached to the first part 120 and second part 125 of the two-part carriage 115. Figs. 3 and 3A show a closer, more detailed view of the gripper assembly 10 and gripper head 140. A first extension 205 has an extension in the x-axis 206 and also has an extension along the z-axis 207 to make an L-shape. The x-axis extension 206 is connected to the first part 120, and the z-axis extension 207 terminates the bottom end of the gripper assembly 10 and is configured to contact an electronic component 220. Similarly, a second extension 210 has an extension in the x-axis 211 and also has an extension along the z-axis 212 to make an L-shape. The x-axis extension 211 is connected to the second part 125, and the z-axis extension 212 terminates the bottom end of the gripper assembly 10 and is configured to contact the electronic component 220.

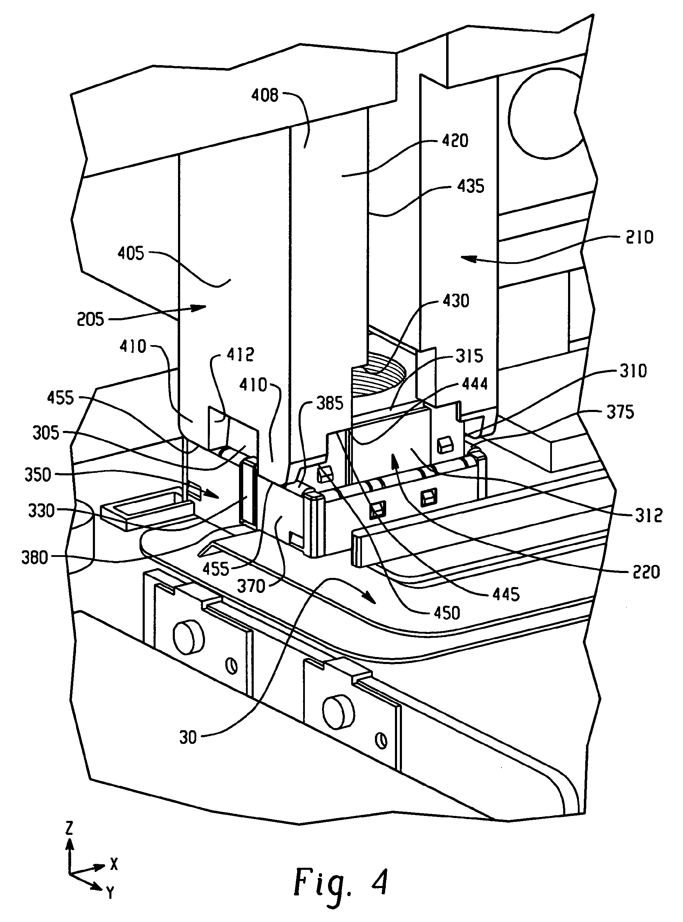

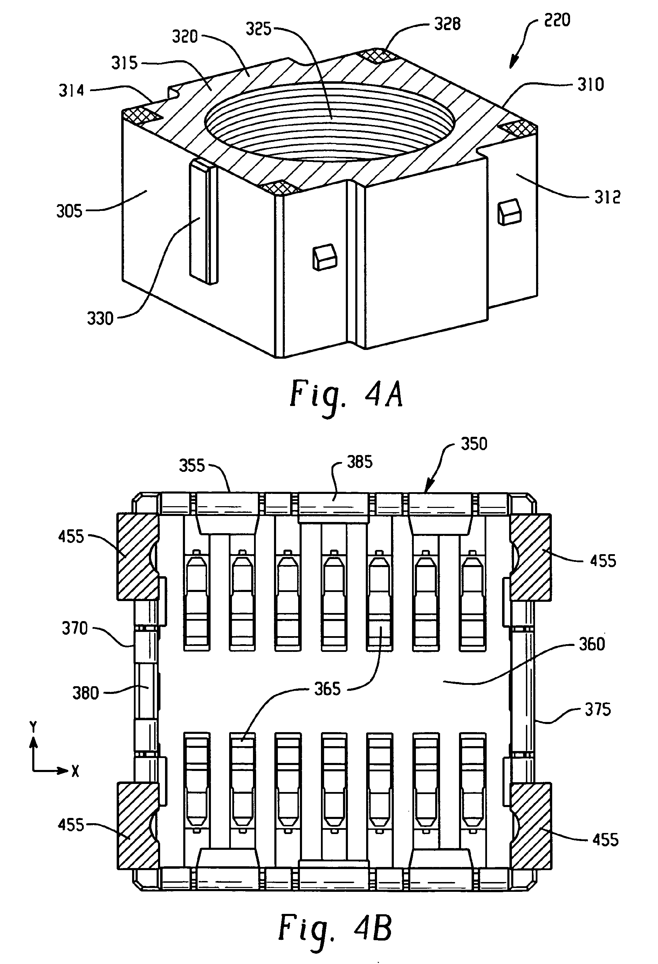

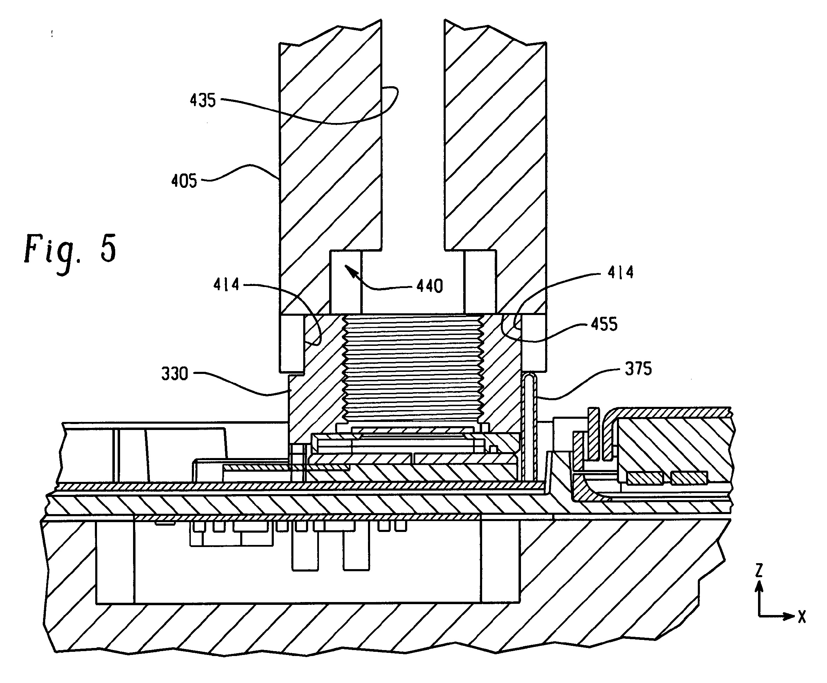

Fig. 4, Fig. 4A, Fig. 4B and Fig. 5 show a closer, more detailed view of how the gripper head 140 interacts with the electronic component 220 and PCB 30.

An electronic component 220 has first and second sides 305, 310 opposite each other, and third and fourth sides 312, 314 opposite each other and perpendicular to the first and second sides 305, 310. A top face 315 of the electronic component has a top-face peripheral area 320 (shaded area Fig. 4A) and a top-face central area 325. Four corner areas 328 (cross-hatched shaded areas in Fig. 4A) are included as part of the top peripheral face 320. The electronic component 220 also has a key 330 on the first side 305. The bottom face of the electronic component 220 has electrical connections. In this example, the electronic component 220 is a camera unit. The camera unit is a pressure sensitive electronic component because the lens disposed on the top face central area 325 cannot withstand the typical pressure used in vacuum-based manufacturing assembly equipment or other machinery or labor that mechanically or manually applies force on the center of the component. Other pressure sensitive electronic components may include, but are not limited to, certain microphones, receivers or speakers.

A socket 350 is electrically and physically connected to the PCB 30 and includes walls 355 circumscribing a socket floor 360 (See Fig. 4B). The socket floor 360 contains several electrical contacts 365 that are electrically coupled to the PCB 30. The socket walls 355 include a first socket wall 370 and a second socket wall 375. A key-hole section 380 is cut-out of the first socket wall 370 and is open to the top of the socket 350. The key-hole section 380 allows entry of the key 330 in the electronic component 220 to aid in proper alignment. The socket walls 355 have a top peripheral face 385 circumscribing the top of the socket 350.

In the example shown in Fig. 4, the first extension 205 and second extension 210 of the gripper head 140 extend down and partially surround the electronic component 220. The gripper head 140 is shown in the closed position, gripping the electronic component 220. In the open position, the first extension 205 and second extension 210 are spaced apart to a distance greater than the x-axis width of the electronic component 220. In this example, the first extension 205 and second extension 210 are mirror images of each other; however, in other examples their particular shapes may differ.

Because the first and second extensions 205, 210 are mirror images of each other, the following description focuses on the first extension 205, but applies to both extensions 205, 210. The first extension 205 has four sides. The first side 405 extends in the y and z planes. At the bottom end of the first side 405, two corner extensions 410 border a notch 412 cut out of the first side 405. The notch 412 is open to the bottom of the gripper head 140, and enables the key 330 on the electronic component 220 to extend between the corner extensions 410 when the gripper head 140 is in the closed position.

Interior surfaces 414 (Fig. 5) of the corner extensions 410 contact the first side 305 (or in the case of the second extension, the second side 310) of the electronic component 220. The corner extensions 410 have a thickness that extends across the x-axis width of the top peripheral face 385 of the socket 350. The interior surfaces 414 of the corner extensions 410 grip the electronic component 220 when the gripper head 140 is in the closed position by pushing against the first and second sides 305, 310 of the electronic component 220. This interior surface 414 may optionally be provided with a high-friction surface to enhance the grip of the gripping head 140. The interior surface 414 may also optionally be provided with a soft or cushioned surface to cushion the force of the grip.

A second side 420 and a third side (not shown) of the first extension 205 run perpendicular to the first side 405 in the x and z planes. In the present example, as the second side 420 and third side extend down the z-axis, they recede in unison away from the center of the gripper head 140 along the x-axis in a stair-stepped manner. The same recessed steps are formed in both sides, thus only the second side is described in detail, with the understanding that the third side has the same form.

Prior to a first recessed step 430, a fourth side 435 (See Fig. 3A), which is opposite the first side 405, extends across the entire width of the gripper head 140 and connects with the third side.

At the first recessed step 430, the gripper head 140 has a recess 440 (Fig. 5) bounded by the interiors of the first side 405, second side 420, and third side, which provides a clearance so the central area 325 of the electronic component 220 is not contacted by the gripper head 140.

At a second recessed step 444, a lip 445 is formed on the bottom side thereof. This lip 445 is an extension that has a thickness in the y and x plane such that when the gripper head 140 is in the closed position it will be situated over the top peripheral face 320 of the electronic component 220. The lip 445 of the first extension 205 may be considered to extend toward the lip 445 of the second extension 210. Specifically, the lip 445 contacts the electronic component 220 at a corner area 328 of the top peripheral face 385 where the electronic component 220 is less susceptible to damage. For example, the top peripheral face 385 and the corner area 390 of the top peripheral face 385 of pressure sensitive camera units are better able to withstand pressure than the central area 325 where the lens is disposed.

As the second side 420 extends down the z-axis from the second 444 to a third recessed step 450, the y-axis thickness of the second side 420 is reduced so that a thin wall is formed that contacts or nearly contacts (e.g. within 3 mm) the third and fourth sides 312, 314 of the electronic component 220.

The third recessed step 450 extends along the x-axis to the edge of the first side 305 of the electronic component 220. After the third recessed step 450, the second side 420 merges into the x-axis thickness of the corner extensions 410 of the first side 405, which extend below the third recessed step 450.

In this example, a bottom surface 455 of the four corner extensions 410 of the gripper head 140 (on both the first and second extensions 205, 210) contacts the top peripheral surface 385 of the socket 350. Specifically, the bottom surface 455 contacts the front and back areas of the first socket wall 370 and the second socket wall 375. In this example, the bottom surface 455 of the corner extensions 410 functions as an insertion depth guide by acting as a stopper against the top peripheral surface 385 of the socket 350. This controls the depth of insertion of the electronic component 220 into the socket 350 and prevents excessive force on the electronic component 220 and the floor 360 of the socket 350. In this example, the distance between the lip 445 and the bottom surface 455 of the corner extensions 410 should be the same as the distance between top peripheral surface 320 of the electronic component 220 and the top peripheral surface 385 of the socket 350 when the electronic component 220 is securely seated in the socket 350. The depth insertion guide feature also ensures a correct orientation on the z-axis by making the top peripheral surface 320 of the electronic component 220 and the top peripheral surface 385 of the socket 350 level.

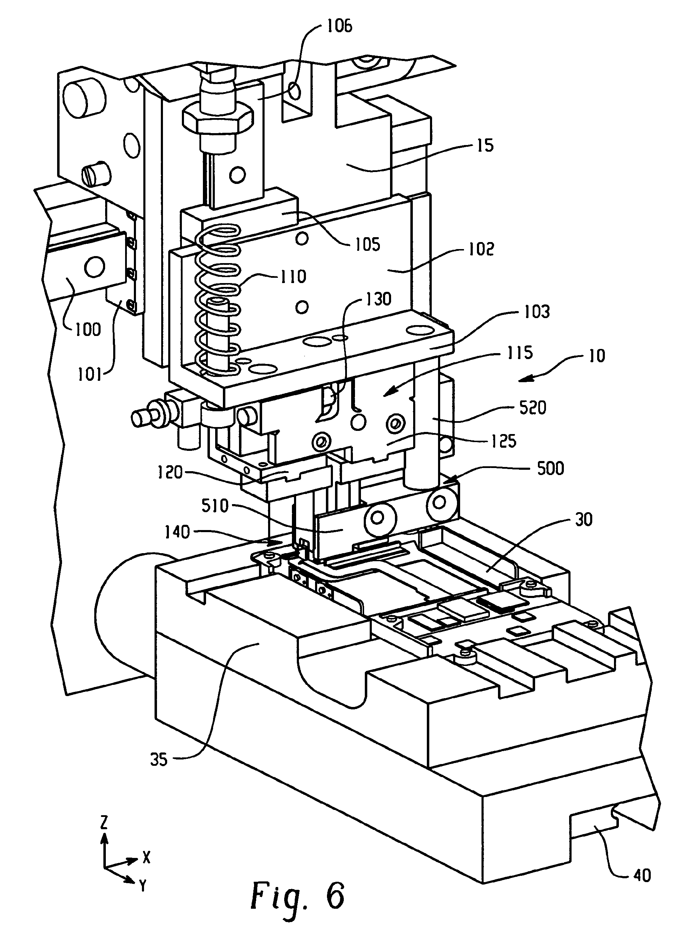

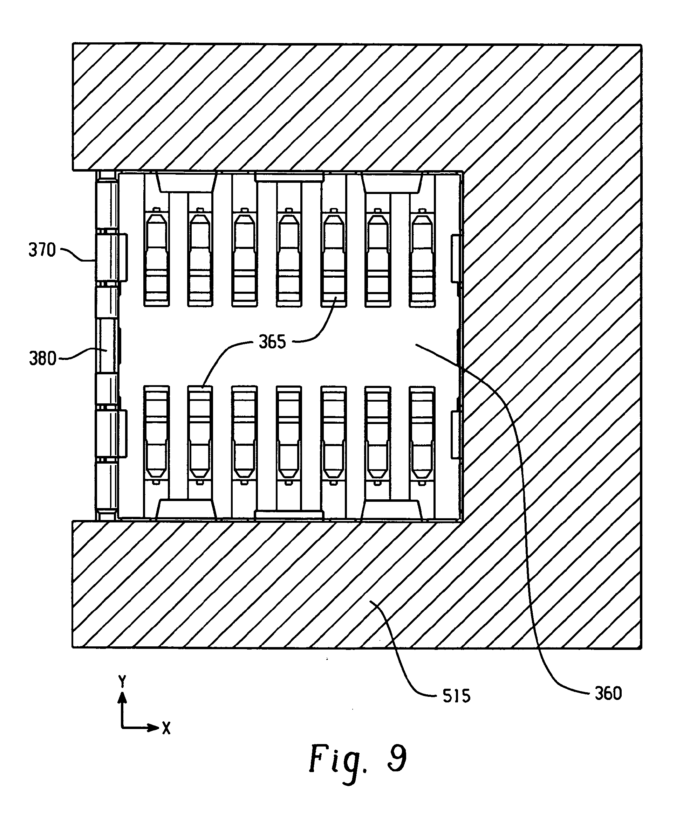

In another example, shown in Figs. 6-9, the depth insertion guide is an independent piece that is separate from the gripper head 140. Fig. 6 shows the same apparatus described above and shown in Figs. 1-5, except an example control block insertion depth guide 500 is added. In this example, the control block insertion depth guide 500 functions as the insertion depth guide instead of the bottom surface 455 of the four corner extensions 410 of the gripper head 140. The separate control block configuration protects the socket 350 from excessive force and functions to ensure that the socket 350 and electronic component 220 are correctly aligned.

The example control block insertion depth guide 500 comprises a control block 510 and an insertion height control rod 520. The example control block 510 is separately mounted and does not move in the x-axis or y-axis, even when the gripper head 140 is sliding on the x-axis to retrieve an electronic component 220 from the tape feeder 45. The control block 510, however, is mounted so that it can slide to an up and a down position along the z-axis.

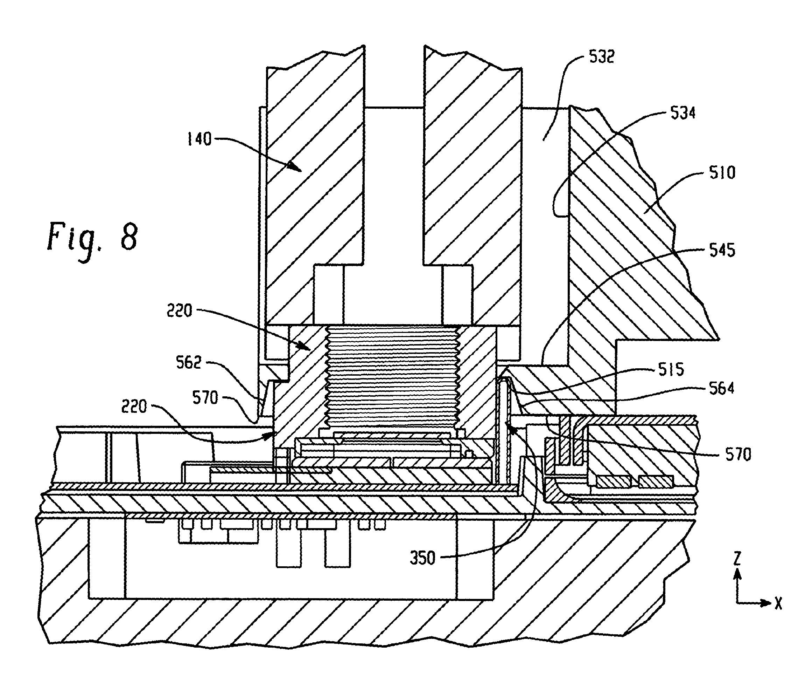

The control block 510 is biased by a spring (not shown) such that the control block 510 will rise to the up position when no other force is applied to it. In the up position, the bottom of the control block 510 is raised above the PCB 35 to allow for clearance of the PCB 35 when the electronic component 220 is inserted (See Fig. 7). In the down position (See Figs. 6 and 8) the control block 510 is pressed down so that a bottom surface 515 of a ledge 545 on the control block 510 contacts the top peripheral surface 385 of the socket 350, thereby stopping the downward motion of the control block 510. Other types of range-limiting stoppers can be utilized alternatively or in conjunction with the above. For example, a fixed surface mounted underneath the control block 510 may be configured to limit the range of the downward motion of the control block 510.

The example insertion height control rod 520 is secured to the bottom ledge 103 of the L-shaped angled mounting plate 102. Thus, the insertion height control rod 520 travels along with the gripper head 140 as it moves in the x- and z-axes. The bottom surface 522 of the insertion height control rod 520 is configured to contact the top surface 512 of the control block 510 when the gripper head 140 moves down along the z-axis. Thus, the insertion height control rod 520 controls the downward (z-axis) range of the gripper head 140 and control block 510.

The control block 510 has a well 530 defined by first, second, and third walls 532, 534, 536, respectively. The well 530 is open to the direction where the electronic component 220 is stored on the tape feeder 45. The control block 510 is positioned so that the z-axis extensions 207, 212 of the gripper head 140 will fit into the well 530 when the gripper head 140 is in position over the socket 350 of the PCB 30. The second wall 534 is recessed enough to allow the gripper head 140 to be in the open position when it is in the well 530. A bottom 540 of the well 530 is open, but is circumscribed by a ledge 545 that runs along the first, second, and third walls 532, 534, 536, respectively. The ledge 545 is tapered so that it is wider at the bottom than at the top, providing a centering feature that directs the gripper head 140, the electronic component 220, or both into the precisely correct position in the socket 350.

A bottom surface 570 of the control block 510 also provides another centering feature. Underneath the ledge 545, first, second, and third under-ledge walls 562, 564, 566 taper outwardly to the bottom surface 570 of the control block 510. The under-ledge walls 562, 564, 566 extend below the socket 350 when the control block 510 is in the down position and function to direct the control block 510 into the precisely correct position over the socket 350. The control block 510, therefore serves to center both the gripper head 140 (with electronic component 220) and the socket 350 into mutual alignment.

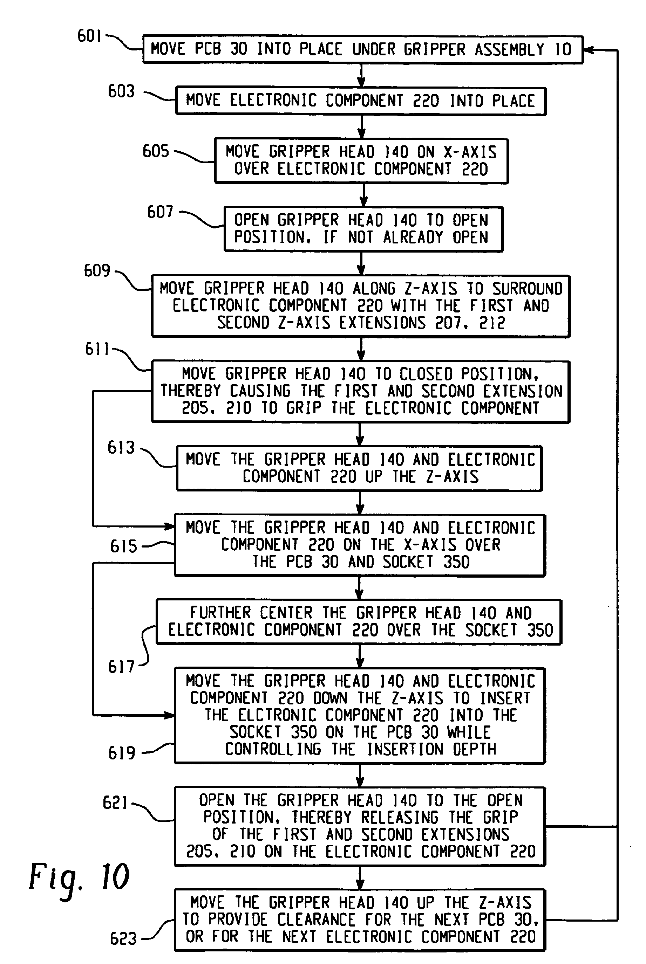

Fig. 10 is a flow chart of an example method for placing an electronic component 220 into a socket 350 disposed on a PCB 30. First, a PCB 30 is moved into place under a gripper assembly 10 (601). The PCB 30 may be situated in a PCB nest 35 and brought under the gripper assembly 10 by traveling along a rail 40 in and out from under the gripper assembly. Concurrently, or before or after step 610, the electronic component 220 is moved into a position proximate to the gripper assembly 10 (603). In one example, the electronic component 220 is placed directly across from the socket 350 on the x-axis.

Once the PCB 30 and electronic component 220 are in place, the gripper head 140, powered, in this example, by a computer-controlled air cylinder 19, moves along the x-axis to a location directly above the electronic component 220 (605). If the gripper head 140 is not open already, the gripper head 140 is moved to the open position (607), thereby causing the first and second extensions 205, 210 on the gripper head 140, and also the first and second z-axis extensions 207, 212, to be spaced apart to a distance greater than the width of the electronic component 220.

The gripper head 140 is then moved down on the z-axis so that the portion of the z-axis extensions 207, 212 that extends below the lip 445 of the gripper head 140 surround portions of at least two opposing sides of the socket 350 (609). The gripper head 140 is then moved to the closed position, thereby causing the first and second z-axis extensions 207, 212 to grip the electronic component 220 underneath the lip 445 of the gripper head 140 (611). At this point, the lip 445 may contact the top peripheral face 320 of the electronic component 220 or it may be slightly above the top peripheral face 320 of the electronic component 220, e.g. 0.01 mm to 5 mm above the top peripheral face 320, such as .5 mm to 4 mm, or 1 mm to 3 mm.

The gripper head 140 is then moved or operated to a closed position, thereby grasping the electronic component 220 between the first z-axis extension 207 and second z-axis extension 212 and beneath the first and second lips 445 (611).

At this point, depending on where the PCB 30 and electronic component 220 originally were located on the z-axis in relation to each other, the gripper head 140 and electronic component 220 can (1) move back up along the z-axis (613) (in a reverse direction from the previous z-axis movement) and then move along the x-axis to a location above the socket 350 on the PCB 30 (615); or (2) move directly along the x-axis to a location above the socket 350 on the PCB 30 (615). Either option may be selected so long as the electronic component 220 and the gripper head 140 are able to clear the top peripheral face 385 of the socket walls 355 as the electronic component 220 and the gripper head 140 are moved over the socket 350. For example, option (2) may be selected if the top peripheral face 385 of the socket walls 355 is situated lower on the z-axis than the surface on which the electronic component 220 was originally situated, and if there are no barriers that would hinder direct movement along the x-axis from the original location of the electronic component 220.

The computer controlled air cylinder 19 is programmed to move the gripper head 140 and electronic component 220 in alignment with the socket 350 on the x-axis (615). The y-axis alignment is controlled in step 601 by the placement of the PCB 30 underneath the gripper assembly 10. Stoppers or location locking mechanisms as known by those of skill in the art may be used to aid in achieving correct alignment. In one example, this alignment, in conjunction with the depth insertion guide function of the corner extensions 410 of the gripper head 140, is sufficient to allow the electronic component 220 to be placed securely into the socket 350.

An optional additional step (617) allows for finer centering of the gripper head 140, electronic component 220 and socket 350. In an example that uses the control block 510 and insertion height control rod, the control block 510 serves to center both the gripper head 140 (with electronic component 220) and the socket 350 into mutual alignment, as described above.

After moving the gripper head 140 and electronic component 220 over the socket 350, the gripper head 140 moves down the z-axis to place the electronic component 220 into the socket 350 (619). The fine centering of step 617 takes place as the electronic component 220 is inserted into the socket 350. As the electronic component 220 is inserted, it encounters some resistance from the socket walls 355, the electrical connections 365 in the socket floor 360, or the socket floor 360 itself. This resistance will tend to push the electronic component 220 up so that it squarely abuts the lips 445 of the gripper head 140. The lips 445 of the gripper head 140 are configured to make the electronic component 220 level in the x-y plane, so that it will be correctly oriented in the socket 350. The lips 445 of the gripper head 140 pushes against the top-face peripheral area 320 of the electronic component 220 to overcome the resistance as it is fully inserted into the socket 350. This ensures that the electronic component 220 is pushed into the socket 350 securely and in the correct orientation while avoiding pressure sensitive areas that may be present at the central area 325 of the electronic component 220. The example insertion depth guides discussed above also aid in providing correct orientation as they press against the top peripheral face 385 of the socket 350.

The insertion depth is controlled to prevent excessive pressure on the electronic component 220, socket 350, and PCB 30. For example, the example insertion depth guides discussed above may be used for this purpose, i.e. the bottom surface 455 of the corner extensions 410 or the control block insertion depth guide 500.

After the electronic component 220 is securely inserted into the socket 350, the gripper head 140 is opened to the open position, thereby releasing the grip of the first and second extensions 205, 210 on the electronic component 220 (621).

At this point another PCB may be moved into place under the gripper assembly 10 (601) and the process can start again. Optionally, to provide greater clearance for the next PCB 30 or the next electronic component the gripper may be moved back up the z-axis (623) before the process begins again at step 601.

While various features of the claimed camera module insertion machine with gripper are presented above, it should be understood that the features may be used singly or in any combination thereof. Therefore, the claimed machine is not to be limited to only the specific examples depicted herein. The scope of the disclosure is accordingly defined as set forth in the appended claims.

## Claims

1. A system comprising:
a pressure sensitive electronic component (220) comprising sides (305, 310) and a top face (315), the top face (315) having a top-face peripheral area (320) and a pressure sensitive top-face central area (325);
a socket (350) comprising a top peripheral surface (385); and
an apparatus (10) for seating the pressure sensitive electronic component (220) within the socket (350) according to claim 7, the apparatus (10) comprising a gripper head (140).

2. The system of claim 1, wherein the pressure sensitive electronic component (220) is selected from the group consisting of: a camera unit, a speaker, a receiver, and a microphone.

3. The system of claims 1 or 2, wherein a bottom surface (455) of the gripper head (140) is the insertion depth guide, whereby the insertion depth guide acts as a stopper against the top peripheral surface (385) of the socket (350) to control the insertion depth of the electronic component (220).

4. The system of claim 1 or 2, wherein the insertion depth guide comprises an insertion height control rod (520) coupled to the gripper (10), the insertion height control rod (520) being configured to (1) contact a separately mounted control block (510), movable only in the z-axis, and (2) to move the control block (510) from an up position to a down position, wherein a bottom surface (515) of the control block (510) is the bottom surface (455, 515) that contacts the top peripheral surface (385) of the socket (350).

5. The system of claim 1, 2, or 4, wherein the control block (510) comprises three-sides (532, 534, 536) encompassing a well (530) with a ledge (545) circumscribing a bottom (540) of the well (530), wherein the ledge (545) comprises tapered sides, the tapered sides of the ledge (545) being configured to direct the electronic component (220), the gripper head (140), or both into alignment with the socket (350).

6. The system of claim 1, 2, 4, or 5, wherein the control block (510) comprises three-sides (532, 534, 536) encompassing a well (530) with a ledge (545) circumscribing a bottom (540) of the well (530), and beneath the ledge (545), tapered under-ledge walls (562, 564, 566) to align the socket (350) with the gripper head (140), the electronic component (220), or both.

7. An apparatus (10) for seating a pressure sensitive electronic component (220) within a socket (350), the component (220) comprising sides (305, 310) and a top face (315), the top face (315) having a top-face peripheral area (320) and a pressure sensitive top-face central area (325), the apparatus (10) comprising:
a gripper support structure (15) comprising a first linear slide mechanism (105) for movement on a z-axis, and a second linear slide mechanism for movement on an x-axis;
a gripper head (140) coupled to the support structure (15), the gripper head (140) comprising a first extension (205) and a second extension (210) having each an interior surface (414), the first extension (205) having a first lip (445) extending toward the second extension (210) and the second extension (210) having a second lip (445) extending toward the first extension;
the first (205) and second (210) extensions being movable to an open and closed position;
an insertion depth guide associated with the gripper head (140), the insertion depth guide having a bottom surface (455, 515) configured to contact a top peripheral surface (385) of the socket (350);
wherein the interior surfaces (414) of the first (205) and second (210) extensions are configured to grip the sides (305, 310) of the component (220) when in the closed position and to retain the component (220) under the lips (445).

8. The apparatus of claim 7 wherein, in the closed position, the lips (445) of the first (205) and second (210) extensions are configured to contact the top-face peripheral area (320) of the component (220).

9. The apparatus of claim 7 or 8, wherein a bottom surface (455) of the gripper head (140) is the insertion depth guide, whereby the insertion depth guide acts as a stopper to limit the insertion depth of the electronic component (220).

10. The apparatus of claim 7 or 8, wherein the insertion depth guide comprises an insertion height control rod (520) coupled to the gripper support structure (15), the insertion height control rod (520) being configured to (1) contact a separately mounted control block (510) and (2) to move the control block (510) from an up position to a down position, wherein the control block (510) acts as a stopper to limit the insertion depth of the electronic component (220).

11. The apparatus of claim 7, 8, or 10, wherein the control block (510) comprises three-sides (532, 534, 536) encompassing a well (530) with a ledge (545) circumscribing a bottom (540) of the well (530), wherein the ledge (545) comprises tapered sides, the tapered sides of the ledge (545) being configured to align the gripper head (140).

12. The apparatus of claim 7, 8, 10, or 11 wherein the control block (510) comprises three-sides (532, 534, 536) encompassing a well (530) with a ledge (545) circumscribing a bottom (540) of the well (530), and beneath the ledge (545), tapered under-ledge walls (562, 564, 566).

13. A method for placing a pressure sensitive electronic component within a socket (350), the component (220) comprising sides (305, 310) and a top face (315), the top face (315) having a top-face peripheral area (320) and a pressure sensitive top-face central area (325), the method comprising the acts of:
operating a gripper head (140) to an open position, the gripper head (140) comprising a first extension (205) and a second extension (210), the first extension (205) having a first lip (445) extending toward the second extension (210) and the second extension (210) having a second lip (445) extending toward the first extension (205);
moving the gripper head (140) on a z-axis to at least partially surround the electronic component (220) with the first extension (205) and the second extension (210);
operating the gripper head (140) to a closed position, thereby grasping the sides (305, 310) of the electronic component (220) between the first extension (205) and second extension (210) and beneath the first and second lips (445);
optionally moving the gripper head (140) in a reverse direction on the z-axis;
moving the gripper head (140) on an x-axis to locate the electronic component (220) over the socket (350);
moving the gripper head (140) on the z-axis to place the electronic component (220) into the socket (350); and
controlling the insertion depth of the electronic component (220) into the socket (350) by an insertion depth guide, the insertion depth guide having a bottom surface (455, 515) configured to contact a top peripheral surface (385) of the socket (350).

14. The method of claim 13, wherein the bottom surface (455) of the first and second lips (445) contacts the top-face peripheral area (320) of the electronic component (220).

15. The method of claim 13 or 14, further comprising controlling the insertion depth of the electronic component (220) by contacting a control block (510) with an insertion height control rod (520), thereby pushing the control block (510) down along the z-axis to a down position, and contacting a bottom surface (515) of the control block (510) with the top peripheral surface (385) of the socket (350).

16. The method of claim 13, 14, or 15, further comprising centering the electronic component (220), wherein the control block (510) comprises three-sides (532, 534, 536) encompassing a well (530) with a ledge (545) circumscribing a bottom (540) of the well (530), wherein the ledge (545) comprises tapered sides, and beneath the ledge (545), tapered under-ledge walls (562, 564, 566);
the tapered sides of the ledge (545) and tapered under-ledge walls (562, 564, 566) directing the electronic component (220), the gripper head (140), or both into mutual alignment with the socket (350).

## Patentansprüche

1. System, das aufweist:
eine druckempfindliche elektronische Komponente (220), die Seiten (305, 310) und eine Oberseite (315) aufweist, wobei die Oberseite (315) einen Oberseite-Umfangsbereich (320) und einen druckempfindlichen Oberseite-Zentralbereich (325) hat;
eine Fassung (350), die eine obere Umfangsfläche (385) aufweist; und
eine Vorrichtung (10) zum Einsetzen der druckempfindlichen elektronischen Komponente (220) in die Fassung (350) gemäß Anspruch 7, wobei die Vorrichtung (10) einen Greiferkopf (140) aufweist.

2. System gemäß Anspruch 1, wobei die druckempfindliche elektronische Komponente (220) aus der Gruppe ausgewählt ist, die besteht aus: einer Kameraeinheit, einem Lautsprecher, einem Empfänger und einem Mikrofon.

3. System gemäß Anspruch 1 oder 2, wobei eine untere Oberfläche (455) des Greiferkopfs (140) die Einsetztiefe-Führung ist, wodurch die die Einsetztiefe-Führung als ein Anschlag gegen die obere Umfangsfläche (385) der Fassung (350) wirkt, um die Einsetztiefe der elektronischen Komponente (220) zu steuern.

4. System gemäß Anspruch 1 oder 2, wobei die Einsetztiefe-Führung einen Einsetzhöhe-Steuerungsstab (520) aufweist, der mit dem Greifer (10) verbunden ist, wobei der Einsetzhöhe-Steuerungsstab (520) konfiguriert ist, (1) einen getrennt angebrachten Steuerungsblock (510) zu kontaktieren, der nur in der Z-Achse bewegbar ist, und (2) den Steuerungsblock (510) von einer oberen Position zu einer unteren Position zu bewegen, wobei eine untere Oberfläche (515) des Steuerungsblocks (510) die untere Oberfläche (455, 515) ist, die die obere Umfangsfläche (385) der Fassung (350) kontaktiert.

5. System gemäß Anspruch 1, 2 oder 4, wobei der Steuerungsblock (510) drei Seiten (532, 534, 536) aufweist, die einen Schacht (530) mit einem Absatz (545) umschließen, der eine Unterseite (540) des Schachts (530) begrenzt, wobei der Absatz (545) sich verjüngende Seiten aufweist, wobei die sich verjüngenden Seiten des Absatzes (545) konfiguriert sind, die elektronische Komponente (220), den Greiferkopf (140), oder beide in Ausrichtung mit der Fassung (350) zu bringen.

6. System gemäß Anspruch 1, 2, 4 oder 5, wobei der Steuerungsblock (510) drei Seiten (532, 534, 536) aufweist, die einen Schacht (530) mit einem Absatz (545) umschließen, der eine Unterseite (540) des Schachts (530) begrenzt, und unter dem Absatz (545) sich verjüngende Unter-Absatz-Wände (562, 564, 566), um die Fassung (350) mit dem Greiferkopf (140), der elektronischen Komponente (220) oder beiden auszurichten.

7. Vorrichtung (10) zum Einsetzen einer druckempfindlichen elektronischen Komponente (220) in einer Fassung (350), wobei die Komponente (220) Seiten (305, 310) und eine Oberseite (315) aufweist, wobei die Oberseite (315) einen Oberseite-Umfangsbereich (320) und einen druckempfindlichen Oberseite-Zentralbereich (325) hat, wobei die Vorrichtung (10) aufweist:
eine Greifer-Trägerstruktur (15), die einen ersten linearen Gleitmechanismus (105) für eine Bewegung auf einer Z-Achse und einen zweiten linearen Gleitmechanismus für eine Bewegung auf einer X-Achse aufweist;
einen Greiferkopf (140), der mit der Trägerstruktur (15) verbunden ist, wobei der Greiferkopf (140) einen ersten Fortsatz (205) und einen zweiten Fortsatz (210) aufweist, die jeweils eine Innenfläche (414) haben, wobei der erste Fortsatz (205) eine erste Lippe (445) hat, die sich in Richtung zu dem zweiten Fortsatz (210) erstreckt, und der zweite Fortsatz (210) eine zweite Lippe (445) hat, die sich in Richtung zu dem ersten Fortsatz erstreckt;
wobei die ersten (205) und zweiten (210) Fortsätze in eine offene und geschlossene Position bewegbar sind;
eine Einsetztiefe-Führung, die zu dem Greiferkopf (140) gehört, wobei die Einsetztiefe-Führung eine untere Oberfläche (455, 515) hat, die konfiguriert ist, eine obere Umfangsfläche (385) der Fassung (350) zu kontaktieren;
wobei die Innenflächen (414) der ersten (205) und zweiten (210) Fortsätze konfiguriert sind, die Seiten (305, 310) der Komponente (220) zu greifen,
wenn in der geschlossenen Position, und die Komponente (220) unter den Lippen (445) zu halten.

8. Vorrichtung gemäß Anspruch 7, wobei, in der geschlossenen Position, die Lippen (445) der ersten (205) und zweiten (210) Fortsätze konfiguriert sind, den Oberseite-Umfangsbereich (320) der Komponente (220) zu kontaktieren.

9. Vorrichtung gemäß Anspruch 7 oder 8, wobei eine untere Oberfläche (455) des Greiferkopfs (140) die Einsetztiefe-Führung ist, wodurch die Einsetztiefe-Führung als ein Anschlag wirkt, um die Einsetztiefe der elektronischen Komponente (220) zu begrenzen.

10. Vorrichtung gemäß Anspruch 7 oder 8, wobei die Einsetztiefe-Führung einen Einsetzhöhe-Steuerungsstab (520) aufweist, der mit der Greifer-Trägerstruktur (15) verbunden ist, wobei der Einsetzhöhe-Steuerungsstab (520) konfiguriert ist, (1) einen getrennt angebrachten Steuerungsblock (510) zu kontaktieren und (2) den Steuerungsblock (510) von einer oberen Position zu einer unteren Position zu bewegen, wobei der Steuerungsblock (510) als ein Anschlag wirkt, um die Einsetztiefe der elektronischen Komponente (220) zu begrenzen.

11. Vorrichtung gemäß Anspruch 7, 8 oder 10, wobei der Steuerungsblock (510) drei Seiten (552, 534, 536) aufweist, die einen Schacht (530) mit einem Absatz (545) umschließen, der eine Unterseite (540) des Schachts (530) begrenzt, wobei der Absatz (545) sich verjüngende Seiten aufweist, wobei die sich verjüngenden Seiten des Absatzes (545) konfiguriert sind, den Greiferkopf (140) auszurichten.

12. Vorrichtung gemäß Anspruch 7, 8, 10 oder 11, wobei der Steuerungsblock (510) drei Seiten (532, 534, 536) aufweist, die einen Schacht (530) mit einem Absatz (545) umschließen, der eine Unterseite (540) des Schachts (530) begrenzt, und unter dem Absatz (545) sich verjüngende Unter-Absatz-Wände (562, 564, 566).

13. Verfahren zum Platzieren einer druckempfindlichen elektronischen Komponente in einer Fassung (350), wobei die Komponente (220) Seiten (305, 310) und eine Oberseite (315) aufweist, wobei die Oberseite (315) einen Oberseite-Umfangsbereich (320) und einen druckempfindlichen Oberseite-Zentralbereich (325) hat, wobei das Verfahren die Vorgänge aufweist:
Betätigen eines Greiferkopfs (140) in eine offene Position, wobei der Greiferkopf (140) einen ersten Fortsatz (205) und einen zweiten Fortsatz (210) aufweist, wobei der erste Fortsatz (205) eine erste Lippe (445) hat, die sich in Richtung zu dem zweiten Fortsatz (210) erstreckt, und der zweite Fortsatz (210) eine zweite Lippe (445) hat, die sich in Richtung zu dem ersten Fortsatz (205) erstreckt;
Bewegen des Greiferkopfs (140) auf einer Z-Achse, um zumindest teilweise die elektronische Komponente (220) mit dem ersten Fortsatz (205) und dem zweiten Fortsatz (210) zu umgeben;
Betätigen des Greiferkopfs (140) in eine geschlossene Position, wodurch die Seiten (305, 310) der elektronischen Komponente (220) zwischen dem ersten Fortsatz (205) und dem zweiten Fortsatz (210) und unter den ersten und zweiten Lippen (445) gefasst werden;
optional Bewegen des Greiferkopfs (140) in eine entgegengesetzte Richtung auf der Z-Achse;
Bewegen des Greiferkopfs (140) auf einer X-Achse, um die elektronische Komponente (220) über der Fassung (350) zu positionieren;
Bewegen des Greiferkopfs (140) auf der Z-Achse, um die elektronischen Komponente (220) in der Fassung (350) zu platzieren; und
Steuern der Einsetztiefe der elektronischen Komponente (220) in die Fassung (350) durch eine Einsetztiefe-Führung, wobei die Einsetztiefe-Führung eine untere Oberfläche (455, 515) hat, die konfiguriert ist, eine obere Umfangsfläche (385) der Fassung (350) zu kontaktieren.

14. Verfahren gemäß Anspruch 13, wobei die untere Oberfläche (455) der ersten und zweiten Lippen (445) den Oberseite-Umfangsbereich (320) der elektronischen Komponente (220) kontaktiert.

15. Verfahren gemäß Anspruch 13 oder 14, das weiter aufweist ein Steuern der Einsetztiefe der elektronischen Komponente (220) durch Kontaktieren eines Steuerungsblocks (510) mit einem Einsetzhöhe-Steuerungsstab (520), **dadurch** Drücken des Steuerungsblocks (510) nach unten entlang der Z-Achse in eine untere Position, und Kontaktieren einer unteren Oberfläche (515) des Steuerungsblocks (510) mit der oberen Umfangfläche (385) der Fassung (350).

16. Verfahren gemäß Anspruch 13, 14 oder 15, das weiter aufweist Zentrieren der elektronischen Komponente (220), wobei der Steuerungsblock (510) drei Seiten (532, 534, 536) aufweist, die einen Schacht (530) mit einem Absatz (545) umschließen, der eine Unterseite (540) des Schachts (530) begrenzt, wobei der Absatz (545) sich verjüngende Seiten und, unter dem Absatz (545) sich verjüngende Unter-Absatz-Wände (562, 564, 566) aufweist:
wobei die sich verjüngenden Seiten des Absatzes (545) und die sich verjüngenden Unter-Absatz-Wände (562, 564, 566) die elektronische Komponente (220), den Greiferkopf (140), oder beide in beiderseitiger Ausrichtung mit der Fassung (350) bringen.

## Revendications

1. Système comprenant :
un composant électronique sensible à la pression (220), comprenant des côtés (305, 310) et une face supérieure (315), la face supérieure (315) comprenant une zone périphérique supérieure (320) et une zone centrale supérieure (325) sensible à la pression ;
un socle (350) comprenant une surface périphérique supérieure (385) ; et
un appareil (10) selon à revendication 7, destiné à installer le composant électronique sensible à la pression (220) à l'intérieur du socle (350), l'appareil (10) comprenant une tête de préhension (140).

2. Système selon la revendication 1, dans lequel le composant électronique sensible à la pression (220) est sélectionné dans le groupe comprenant : une unité de caméra, un haut-parleur, un récepteur et un microphone.

3. Système selon la revendication 1 ou 2, dans lequel une surface inférieure (455) de la tête de préhension (140) constitue le guide de profondeur d'insertion, si bien que le guide de profondeur d'insertion joue le rôle de butée sur la surface périphérique supérieure (385) du socle (350) afin de commander la profondeur d'insertion du composant électronique (220).

4. Système selon la revendication 1 ou 2, dans lequel le guide de profondeur d'insertion comprend une tige de commande de la hauteur d'insertion (520) couplée à la pince (10), la tige de commande de la hauteur d'insertion (520) étant configurée pour (1) entrer en contact avec un bloc de commande monté séparément (510) et ne pouvant se déplacer que sur l'axe z et pour (2) déplacer le bloc de commande (510) entre une position haute et une position basse, dans lequel une surface inférieure (515) du bloc de commande (510) est la surface inférieure (455, 515) qui entre en contact avec la surface périphérique supérieure (385) du socle (350).

5. Système selon la revendication 1, 2 ou 4, dans lequel le bloc de commande (510) comprend trois côtés (532, 534, 536) délimitant un puits (530) avec un rebord (545) entourant le fond (540) du puits (530), dans lequel le rebord (545) possède des côtés chanfreinés, les côtés chanfreinés du rebord (545) étant configurés pour diriger le composant électronique (220), la tête de préhension (140) ou tous les deux pour qu'ils s'alignent avec le socle (350).

6. Système selon la revendication 1, 2, 4 ou 5, dans lequel le bloc de commande (510) comprend trois côtés (532, 534, 536) délimitant un puits (530) avec un rebord (545) entourant le fond (540) du puits (530), et, au-dessous du rebord (545), des parois chanfreinées inférieures au rebord (562, 564, 566) destinées à aligner le socle (350) avec la tête de préhension (140), le composant électronique (220) ou les deux.

7. Appareil (10) destiné à installer un composant électronique sensible à la pression (220) à l'intérieur d'un socle (350), le composant (220) comprenant des côtés (305, 310) et une face supérieure (315), la face supérieure (315) comprenant une zone périphérique supérieure (320) et une zone centrale supérieure (325) sensible à la pression, l'appareil (10) comprenant :
une structure de support de pince (15) comprenant un premier mécanisme de déplacement linéaire (105) pour effectuer des mouvements sur un axe z et un second mécanisme de déplacement linéaire pour effectuer des mouvements sur un axe x ;
une tête de préhension (140) couplée à la structure de support (15), la tête de préhension (140) comprenant une première extension (205) et une seconde extension (210) ayant chacune une surface intérieure (414), la première extension (205) possédant une première lèvre (445) s'étendant dans la direction de la seconde extension (210) et la seconde extension (210) possédant une seconde lèvre (445) s'étendant en direction de la première extension ;
la première (205) et la seconde (210) extension pouvant se déplacer entre une position ouverte et une position fermée ;
un guide de profondeur d'insertion associé à la tête de préhension (140), le guide de profondeur d'insertion possédant une surface inférieure (455, 515) configurée pour entrer en contact avec une surface périphérique supérieure (385) du socle (350) ;
dans lequel les surfaces intérieures (414) de la première (205) et de la seconde (210) extension sont configurées pour saisir les côtés (305, 310) du composant (220) lorsqu'elles sont dans la position fermée et pour maintenir le composant (220) au-dessous des lèvres (445).

8. Appareil selon la revendication 7, dans lequel, lorsqu'elles sont dans à position fermée, les lèvres (445) de la première (205) et de la seconde (210) extension sont configurées pour entrer en contact avec à zone périphérique supérieure (320) du composant (220).

9. Appareil selon la revendication 7 ou 8, dans lequel une surface inférieure (455) de la tête de préhension (140) constitue le guide de profondeur d'insertion, si bien que le guide de profondeur d'insertion joue le rôle de butée afin de limiter la profondeur d'insertion du composant (220).

10. Appareil selon la revendication 7 ou 8, dans lequel le guide de profondeur d'insertion comprend une tige de commande de la hauteur d'insertion (520) couplée à la structure de support de pince (15), la tige de commande de la hauteur d'insertion (520) étant configurée pour (1) entrer en contact avec un bloc de commande monté séparément (510) et pour (2) déplacer le bloc de commande (510) entre une position haute et une position basse, dans lequel le bloc de commande (510) joue le rôle de butée afin de limiter la profondeur d'insertion du composant électronique (220).

11. Appareil selon la revendication 7, 8 ou 10, dans lequel le bloc de commande (510) comprend trois côtés (532, 534, 536) délimitant un puits (530) avec un rebord (545) entourant le fond (540) du puits (530), dans lequel le rebord (545) possède des côtés chanfreinés, les côtés chanfreinés du rebord (545) étant configurés pour aligner la tête de préhension (140).

12. Appareil selon la revendication 7, 8, 10 ou 11, dans lequel le bloc de commande (510) comprend trois côtés (532, 534, 536) délimitant un puits (530) avec un rebord (545) entourant le fond (540) du puits (530) et, au-dessous du rebord (545), des parois chanfreinées inférieures au rebord (562, 564, 566).

13. Procédé de placement d'un composant électronique sensible à la pression dans un socle (350), le composant (220) comprenant des côtés (305, 310) et une face supérieure (315), la face supérieure (315) comprenant une zone périphérique supérieure (320) et une zone centrale supérieure (325) sensible à la pression, le procédé comprenant les étapes consistant à :
placer une tête de préhension (140) dans une position d'ouverture, la tête de préhension (140) comprenant une première extension (205) et une seconde extension (210), la première extension (205) possédant une première lèvre (445) s'étendant dans la direction de la seconde extension (210) et la seconde extension (210) possédant une seconde lèvre (445) s'étendant en direction de la première extension ;
déplacer la tête de préhension (140) sur un axe z pour entourer au moins partiellement le composant électronique (220) à l'aide de la première extension (205) et de la seconde extension (210) ;
placer la tête de préhension (140) dans une position de fermeture, en saisissant ainsi les côtés (305, 310) du composant électronique (220) entre la première extension (205) et la seconde extension (210) et au-dessous des première et seconde lèvres (445) ;
en option, déplacer la tête de préhension (140) dans la direction opposée sur l'axe z ;
déplacer la tête de préhension (140) sur un axe x pour positionner le composant électronique (220) au-dessus du socle (350) ;
déplacer la tête de préhension (140) sur l'axe z pour placer le composant électronique (220) dans le socle (350) ; et
contrôler la profondeur d'insertion du composant électronique (220) dans le socle (350) à l'aide d'un guide de profondeur d'insertion, le guide de profondeur d'insertion possédant une surface inférieure (455, 515) configurée pour entrer en contact avec une surface périphérique supérieure (385) du socle (350).

14. Procédé selon la revendication 13, dans lequel la surface inférieure (455) des première et seconde lèvres (445) entre en contact avec la zone périphérique supérieure (320) du composant électronique (220).

15. Procédé selon la revendication 13 ou 14, comprenant en outre l'étape consistant à contrôler la profondeur d'insertion du composant électronique (220) en entrant en contact avec un bloc de commandé (510) à l'aide d'une tige de commande de la hauteur d'insertion (520), ce qui pousse le bloc de commande (510) sur l'axe z vers une position basse et en faisant entrer en contact une surface inférieure (515) du bloc de commandé (510) avec la surface périphérique supérieure (385) du socle (350).

16. Procédé selon la revendication 13, 14 ou 15, comprenant en outre les étapes consistant à centrer le composant électronique (220), dans lequel le bloc de commande (510) comprend trois côtés (532, 534, 536) délimitant un puits (530), avec un rebord (545) entourant le fond (540) du puits (530), dans lequel le rebord (545) possède des côtés chanfreinés et, au-dessous du rebord (545), des parois chanfreinées inférieures au rebord (562, 564, 566) ;
les côtés chanfreinés du rebord (545) et les parois chanfreinées inférieures (562, 564, 566) dirigeant le composant électronique (220), la tête de préhension (140) ou tous les deux pour les mettre en alignement avec le socle (350).
